Europäisches Patentamt

European Patent Office

Office européen des brevets

(11) Publication number: **0 517 122 A2**

# EUROPEAN PATENT APPLICATION

(21) Application number: **92109158.3**

(22) Date of filing: **30.05.92**

(51) Int. Cl.5: **G03H 1/02**, G03F 7/00, G02B 5/32

(30) Priority: **03.06.91 US 709173**

(43) Date of publication of application:
**09.12.92 Bulletin 92/50**

(84) Designated Contracting States:
**DE FR GB IT**

(71) Applicant: **E.I. DU PONT DE NEMOURS AND COMPANY**
**1007 Market Street**
**Wilmington Delaware 19898(US)**

(72) Inventor: **Oren, Moshe**
**625 Kilburn Road**
**Wilmington, Delaware 19803(US)**
Inventor: **Shvartsman, Felix P.**
**2201 Valley Avenue**
**Wilmington, Delaware 19810(US)**

(74) Representative: **Werner, Hans-Karsten, Dr. et al**
**Deichmannhaus am Hauptbahnhof**
**W-5000 Köln 1(DE)**

(54) Method for making high efficiency volume phase holograms.

(57) A method for making volume phase Holographic Optical Elements derived from binary intensity Computer Generated Holograms, which utilizes a photohardened refractive index-modulatory polymer sandwiched between two transparent, substantially identical, dimensionally stable substrates. The photohardened refractive index-modulatory polymer is imaged by intimately contacting the photosensitive polymer layer with a computer generated relief image photomask-master and passing actinic radiation through the photomask-master in order to change the refractive index of the exposed areas of the photopolymer to produce a volume phase Holographic Optical Element.

## Cross Reference to Related Patent Applications

This application is a continuation-in-part of copending U.S. patent application S.N. 07/687,059 filed April 18, 1991, which is a continuation-in-part of copending U.S. patent application S.N. 07/375,100 filed June 30, 1989.

## Field of the Invention

This invention relates to a method for malting Holographic Optical Elements (HOEs) and, more particularly, volume phase Holographic Optical Elements derived from binary intensity Computer Generated Holograms (CGHs).

## Background of the Invention

CGHs are numerically designed diffractive elements which can create arbitrary optical wavefronts from just their mathematical description. This makes the CGHs very useful in a wide range of applications, such as optical interconnects, optical scanners, array generators, and optical signal processing. Methods of generating such holograms are well known to the art, and they are described in the following articles, among others.

P. A. Lowrence; Appl. Optics, 26 3649 (1987)

W. J. Aossack; Optic Comm. 68 97 (1988)

N. Roberts, Appl. Optics, 28 31 (1989)

Compared to conventional optics, CGHs can be lighter, more versatile and are cheaper to produce. In many cases they can perform functions which are unattainable with conventional optics.

The first step in the fabrication process of a CGH consists of providing an exact mathematical description of the desired CGH transmittance function, $t(x,y)$. An optical beam with a complex amplitude $f(x,y)$ impinging on the CGH can be described, immediately behind the CGH, by $f(x,y) \, {}^*t(x,y)$. Typically the function $t(x,y)$ is sampled in a two dimensional grid and encoded in a binary format that can be recorded into a photolithographlc mask, such as a chrome mask. This encoding can be accomplished by using one of the many techniques described in the literature.

In one such approach proposed by Lohman (Appl. Optics, 6 1739 p. 67), the CGH area is divided into an array of cells. In each cell $t(x,y)$ is represented by a rectangular opening in the chrome the height of which is proportional to the amplitude of $t(x,y)$, and its lateral position is proportional to the phase of $t(x,y)$. Such CGH produced of a thin film of chromium is referred to as thin hologram and results in diffraction efficiency of about 6%. Multilevel surface relief phase-only CGHs (also referred to as binary phase-only CGH) can produce diffraction efficiencies approaching 100% but they are difficult to fabricate and require elaborate photolithographic processes. Yet, because of the high diffraction efficiency achieved, most current interest is focused on surface relief binary phase CGHs. Typically the binary data is used to fabricate a Cr-on-glass mask, which provides a binary intensity pattern. This pattern is then transferred into a phase-only medium, using one of the techniques described below.

In the binary phase CGH, the holographic medium changes only the phase of the impinging optical beam, and the change assumes only finite discrete levels.

The most accurate method to date for fabricating a binary high efficiency CGH is based on a surface relief approach. In this approach, the desired CGH pattern is first etched into a Cr-mask, then the pattern is transferred and etched into the holographic medium using conventional photolithographic techniques, as described for example by B. Veldkamp and G. J. Swanson; SPIE Proc. of the Int. Conf. on CGH, Vol. 437 p. 54 (1985), and by T. Logue and M. L. Chisholm, SPIE Proc. of the Int. Conf. on CGH, Vol. 1052, p. 19 (1989).

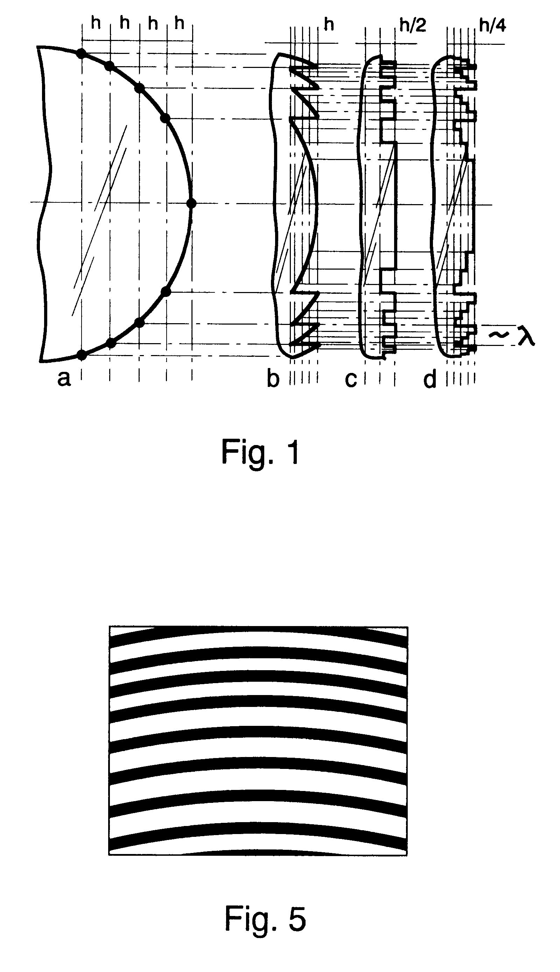

Typically, the pattern is etched into a silicon dioxide ($SiO_2$) layer grown on a Si wafer, or directly onto an optically flat quartz plate forming a phase-only CGH. Figure 1 illustrates the fabrication of a diffractive lens using this approach. In this case a two-step photolithographic process with reactive ion etching (RIE) produces a 4-level approximation to the phase function describing the lens. The object (a) represents the surface of the lens; (b) is the lens kinoform, representing the lens surface curvature modulus $2\pi$ in a multisected form; (c) is the first two-level approximation to this surface, produced in a transparent material by a photolithographic masking process followed by etching; an additional masking step followed by etching produce object (d), which is a 4 level approximation of the kinoform.

The maximum diffraction efficiency of these CGHs is 40% for the two level device and 81% for the four level device. Higher efficiency can be obtained by additional level etching of the $SiO_2$. This requires

additional photolithographic steps, however, which makes it an expensive and lengthy process.

Another approach for fabricating two level phase-only CGH, which is widely known to the artisans in the field, is based in coating a substrate with a photoresist, exposing through a mask containing the CGH pattern, developing, and then coating with a highly reflective thin metallic layer, such as aluminum. The result is a two-level phase CGH having a maximum diffraction efficiency of 40%. This efficiency can be achieved when the photoresist thickness is ($\lambda$/2), where $\lambda$ is the radiation wavelength.

Another method used to fabricate CGH, known as bleaching. is described by Collier, Buckardt and Lin in Optical Holography, Academic Press, 1971. The method involves forming the CGH pattern as an intensity pattern into a conventional photographic emulsion and then treating the emulsion by a process known as "bleaching". This process converts the silver in the emulsion to a transparent compound the index of refraction of which differs from that of the gelatin containing the silver, which results in a pure phase hologram. The reproducibility of the bleaching process is difficult to control, and thus this method is more widely used in the field of graphic arts holography rather then making CGHs.

## Brief Summary of the Invention

The invention therefore relates to a method for making Holographic Optical Elements (HOEs), and more particularly volume phase Holographic Optical Elements derived from binary intensity Computer Generated Holograms (CGHs).

In more specific terms, this invention pertains to a method for forming a volume phase optical element comprising the steps of:

(1) forming a relief image photomask-master having recessed and protruding areas which contrast in opacity and transparency and represent a binary intensity computer generated hologram;

(2) applying a refractive index-modulatory photosensitive dry film on the photomask-master in a manner that one of the surfaces of the dry photosensitive film is in conformation with the relief image of the photomask master;

(3) passing actinic radiation through the transparent areas of the photomask-master thereby hardening and effecting a change of at least 0.001 in the refractive index of the exposed areas of the photosensitive dry film;

(4) removing the refractive index-modulatory photosensitive dry film from the photomask-master; and

(5) laminating the refractive index-modulatory photosensitive dry film between two transparent substrates with optical adhesive sandwiched thereinbetween.

Among the advantages characterizing this invention are the following:

* It can be used to fabricate high efficiency CGHs using a simple process with a single photolithographic step and no wet processing is required. Those provide an important advantage compared to dichromated gelatine.

* High diffraction efficiency is obtained because the CGH is based on a volume phase-only design.

* It is low cost; the CGH is fabricated into photopolymer which can be easily spun, laminated, sprayed, curtain coated, doctor blade coated, wound-wire coated, or otherwise applied on a variety of substrates, and it requires only one contact printing step.

## Brief Description of the Drawing

The Drawing consists of five figures as follows:

Figure 1 is a schematic representation of conventional steps involved in the construction of a Fresnel Lens.

Figures 2A-F are schematic representations of the individual steps of the method of the invention as follows:

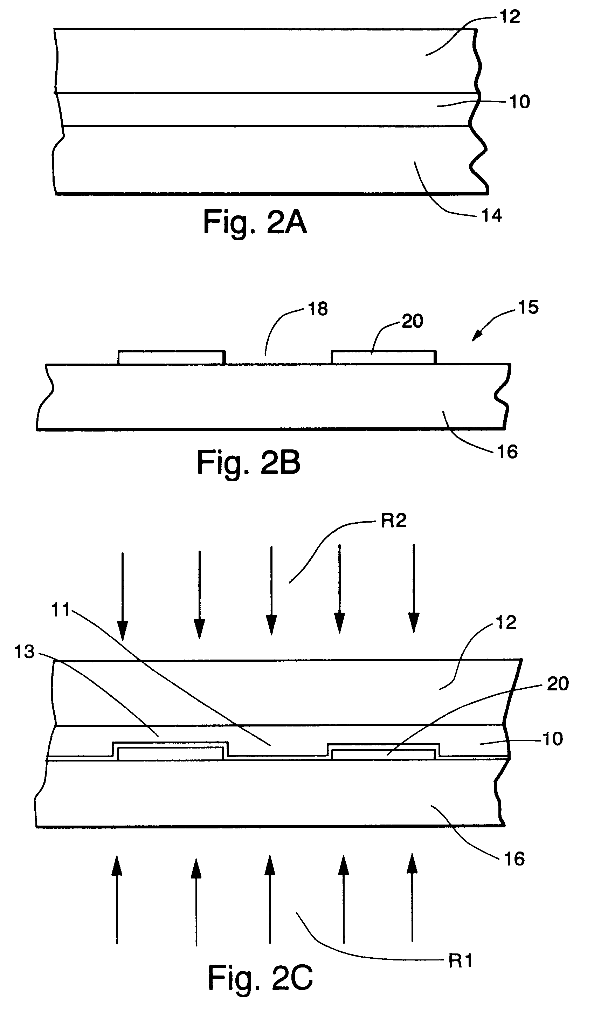

Figure 2A shows a refractive index-modulatory photosensitive dry film sandwiched between two protective support layers.

Figure 2B is a schematic representation of a photomask-master.

Figure 2C illustrates schematically a laminate of a refractive index-modulatory photosensitive dry film and photomask-master, in which the dry film conforms to the protrusions and recessed areas of the photomask-master.

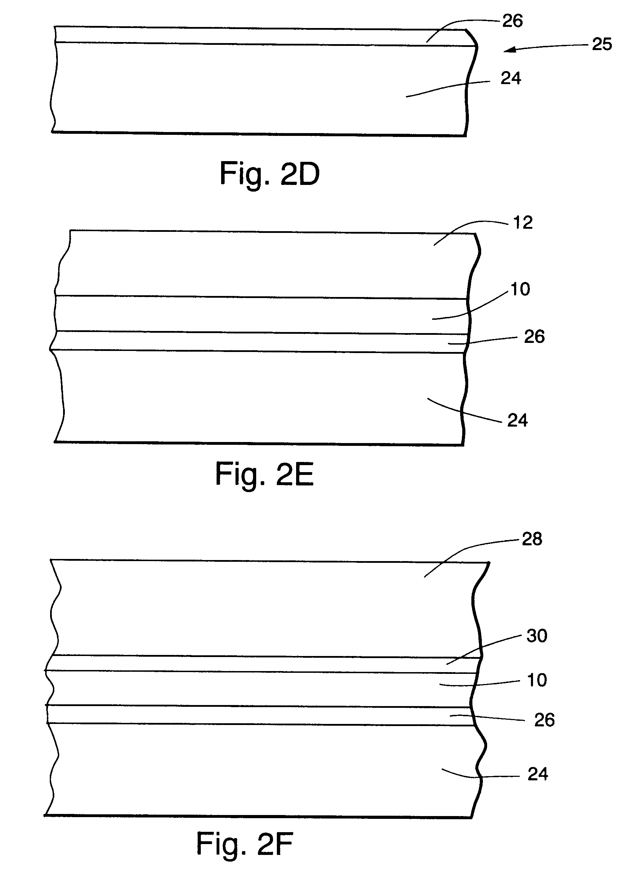

Figure 2D shows a transparent dimensionally stable substrate with an optical adhesive layer laminated on it.

Figure 2E shows a refractive index-modulatory photosensitive dry film sandwiched between a protective support film and a transparent dimensionally stable substrate with a layer of optical adhesive inbetween, and

Figure 2F shows a refractive index-modulatory photosensitive dry film sandwiched between two transparent dimensionally stable substrates with a layers of optical adhesive thereinbetween.

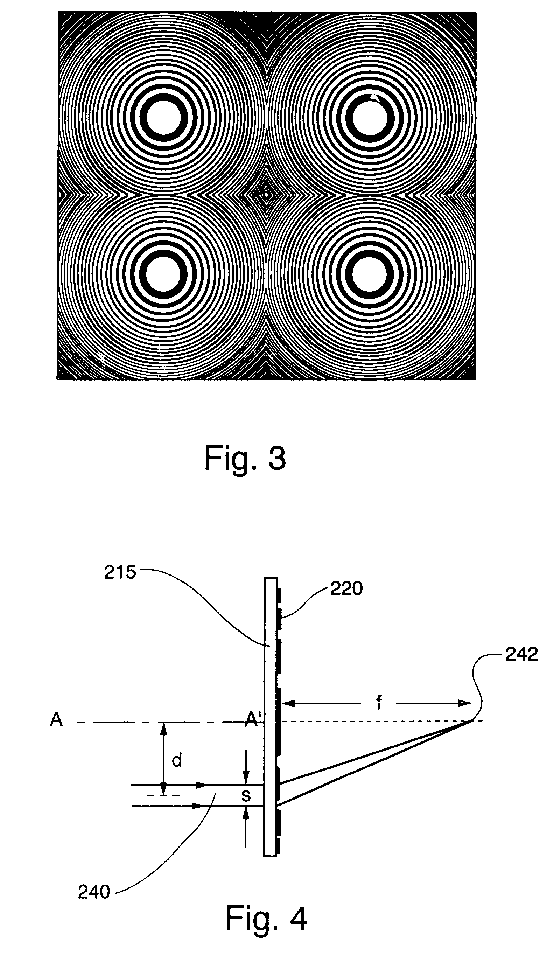

Figure 3 illustrates a micrograph of four square-shaped Fresnel Zone Plates fabricated on a photomask-master, and then transferred to the refractive index-modulatory photosensitive dry film.

Figure 4 illustrates the characteristics of an off-axis Fresnel lens in the form of a photomask-master.

Figure 5 is a schematic representation of a micrograph of a part of an off-center lens fabricated on refractive index-modulatory photosensitive dry film.

Detailed Description of the Invention

A. Substrate

The substrate functions primarily as a dimensionally stable support for the photohardened information-carrying layer. It may be either rigid or flexible. To function as a suitable substrate, the substrate should (1) be substantially transparent to the radiation for which it is intended to function, (2) be uniformly thick across the entire active surface area, (3) have a refractive index matched closely to the photohardened layer, and (4) have a geometry suitable for the end use contemplated.

The blank substrate can be formulated from a variety of polymeric materials, provided that suitable optical criteria are met. Typical of such polymeric materials are poly(methyl methacrylates), polycarbonates and the like. Of these, polycarbonates are preferred due to their better dimensional stability during environmental changes. In some instances, glass, quartz or other transparent inorganic materials may be used as the substrate. Typically, polymeric materials are preferred due to their low cost and the ease of processing.

Suitable shapes of substrates maybe formed by conventional molding methods, such as injection molding or injection/compression molding methods, or they may be cut or stamped from preformed sheets of the substrate material. The geometry of the substrate may be formed before or after lamination of the photohardenable layer. It is also possible to carry out all the manufacturing steps of the invention before cutting or stamping the appropriate shape from the processed sheet laminate.

B. Refractive Index-Modulatory Photosensitive Layer

As used herein, the term "refractive index-modulatory photosensitive layer" means a substantially solvent-free photosensitive solid organic polymeric layer which, upon exposure to actinic radiation, undergoes both hardening and a refractive index change of at least 0.001 and preferably 0.005-0.07. By the term "solvent-free" is meant that the solvent content is on the order of 1000 ppm by weight or less. The essential components of this layer are:

(a) thermoplastic solid polymeric binder,

(b) liquid ethylenically unsaturated monomer which as a boiling point above 100°C and is capable of addition polymerization, and

(c) a photoinitiator system that activates polymerization of the unsaturated monomer upon exposure to actinic radiation.

Refractive index-modulatory photosensitive dry layers of the type which are suitable for use in the invention are widely known in the prior art. However, particularly preferred refractive index-modulatory photosensitive dry film materials are those disclosed in U.S. 3,658,526 to Haugh, U.S. 4,942,102 to keys and U.S. 4,942,112 to Monroe et al. It will be recognized by those skilled in the photopolymer arts that the hardening of such materials upon exposure to actinic radiation may be by the mechanism of addition polymerization, crosslinking between polymer chains or both. They may be applied to the substrate by such means as casting or spin coating a solvent solution or dispersion of the material, or any other known to the art techniques.

As will be explained in detail hereinbelow, the refractive index-modulatory photosensitive layers to be used in the invention must contain at least one each of liquid unsaturated monomer and a solid polymeric binder. They may, however, contain more than one monomer and/or more than one binder component so long as the essential liquid monomer and solid binder components are both present. For example, the binder component may be comprised of a single solid binder polymer or it may be a mixture of solid and liquid binders or a mixture of different solid binders. Likewise, the monomer component may be comprised of a single liquid monomer or it may be a mixture of solid and liquid monomers or a mixture of different liquid monomers.

4

The refractive indices (RI) of the monomer and binder may vary widely. For example, the layer may be comprised of low RI monomer and low RI binder as in the above-referred Haugh patent. On the other hand, the layer may be comprised of low RI monomer and high RI binder or high RI monomer and low RI binder as disclosed in the Keys and Monroe patents. In any event, it is essential that upon photohardening the layer undergo an RI shift of at least 0.01 and preferably 0.05-0.07. It is also preferable that the refractive index attains a higher value upon exposure to actinic radiation. Refractive index shift is determined with 632.8 nm radiation from a transmission grating having a spatial frequency of about 1000 lines per millimeter by the procedure set out in U.S. 4,942,112 at Column 6, line 33 through Column 7, line 54.

Though the precise mechanism by which the photosensitive layers are effective in the invention is not fully understood, it is believed that the RI differences which are essential to the operability of the invention are the result of "internal mass transport" which takes place during the initial exposure of the film to actinic radiation and creates compositional gradients between the exposed and unexposed areas of the dry film layer. In particular, it is believed that during the initial imaging step, monomer diffuses form the regions which are not lightstruck into the lightstruck regions where polymerization and/or crosslinking is taking place. This diffusion of monomer creates a marked compositional gradient between the exposed and unexposed areas of the film which become fixed upon flood exposure. These areas are then permanently detectable by their difference In RI. This mechanism is discussed more fully in Wopschall et al., Appl. Opt. 11, 2096 (1972), Tomlinson et al. in Adv. in Photochem., Vol. 12, J. N. Pitts et al., eds., Wiley-Interscience, New York, 1980, pp. 201-281 and in B. M. Monroe, J. Imag. Sci., in press.

As used herein, the term "dry photohardenable film" or "dry photohardenable layer" refers to a substantially solvent-free polymeric layer having a creep viscosity of about 20 megapoises or greater and preferably between about 100 and 200 megapoises, as measured with a parallel plate rheometer. Such "dry photohardenable layers" are contrasted with conventional liquid photohardenable layers which typically have viscosities of about several hundred poises or less. For the purpose of this invention, viscosity is measured as creep viscosity with a parallel plate rheometer using a Du Pont Model 1090 thermal Mechanical Analyzer. In this procedure, a 0.036 inch thick sample is placed in contact between two flat discs (about 0.25 inch diameter). A quartz probe which is capable of accepting additional weights is positioned atop the upper disc and the same/disc assembly is maintained at constant temperature of 40°C and RH of 44% throughout the measurement. Creep viscosity is calculated from the rate of decrease of sample thickness under equilibrated conditions. The 0.036 inch sample is prepared by laminating together sufficient layers of the test film to obtain the desired thickness.

Since the photohardenable layer is relatively thin, it is usually sandwiched between two temporary support films, typically of the polyester family. These temporary films, which are preferably transparent may be removed easily by a peeling action.

The refractive index-modulatory photosensitive film, in the form of a photohardenable layer in the optical elements of this invention, preferably has a thickness in the range of 20-60 micrometers. For thickness significantly lower than 20 micrometers or considerably higher than 60 micrometers, the diffraction efficiency drops rapidly.

C. Conforming and Exposing

After removing one of the temporary support films, the free surface of the photohardenable layer is pressed at room temperature on a relief image photomask-master having recessed and protruding areas which contrast in opacity and transparency, so that the photohardenable layer conforms to the recessed and protruding areas. This conformance is very important to avoid radiation scattering during exposure.

While simple hand pressure is sufficient to embed the photomask-master surface into the photohardenable layer, use of a press is preferred where uniform pressure across the surface can be applied momentarily to insure complete conformity of the layer surface to the photomask-master surface. Similarly, the photomask-master can be uniformly embedded into the photohardenable layer by passing the aligned laminate/photomask through the nip of a pressure roll laminator, optionally followed by the use of a press. After the image of the photomask-master has been uniformly embedded in the photohardenable layer, pressure may be relaxed or removed and the photohardenable layer then exposed to actinic radiation passing through the photomask-master. Alter the imagewise exposure, it is preferable to conduct flood exposure to the total area of the photohardenable layer in order to stabilize the photohardenable layer. This may be achieved through the remaining transparent support film. Alternatively, pressure may be maintained during actinic exposure.

It is to be noted that depending on the particular case, it is preferable to raise the temperature of the photohardenable layer and maintain it in the range of 30-80°C during the exposure step. A more preferred temperature range is 50-70°C.

It is also to be noted that the process of conforming the photohardenable layer with the photomask-master can be considered an embossing process to the extent that "bosses" or protrusions are formed in the film by the conforming operation. The surface relief aspects of the photohardened layer are of no significance because the optical properties of the products of the invention are derived from the RI properties of the dry film, not from the three dimensional configuration of the conformed layer.

As used herein, the term "photomask-master" refers to a high resolution binary intensity computer generated hologram photomask having a conventional opaque metal layer, e.g., chromium, supported on a substrate such as glass or quartz. This master is prepared in a conventional manner as aforementioned and by using positive-acting electron beam resist materials, etc. as described in Bowden, et al., J. Electrochem. Soc., Solid-State Science & Technology, Vol. 128, No. 6, pp. 1304-1313.

D. Curable Adhesive

Because of the limited adhesion properties of some polymer layers, it is preferred in the practice of the invention to interpose a layer of curable adhesive between such a polymer layer and the adjacent layer. For example, in the practice of the invention as set out in Claim 1, it is preferred to interpose a curable adhesive between the photohardenable active layer and the adjacent transparent substrate. In this instance, it is essential that the adhesive possess good optical properties so that it does not interfere with the passage of light from the substrate to refractive index-modulatory photosensitive dry film.

Such optical adhesives are usually optically clear, solvent-free, viscous liquid or tacky dry polymers of various kinds, including photosensitive polymers such as acrylates and methacrylates similar to those used in the photopolymer layers of the invention. One-part adhesives, and especially photocurable ones, are therefore preferred which upon exposure to ultraviolet light thicken usually in seconds and cure usually in minutes.

An example of a preferred optical adhesive is Cromalin C4/CP, sold by DuPont, Wilmington, Delaware in the form of a film sandwiched between temporary protective support films.

Other examples of suitable optical adhesives are those manufactured by Norland Products, Inc., New Brunswick, NJ under the trade name of Norland Optical Adhesives. These preferred adhesives meet Federal Specification MIL-A3902C. After application to the surface to be bonded, they are cured in two steps: (1) a short pre-cure with ultraviolet light of sufficient duration to set the bond; and (2) a longer ultraviolet light cure to obtain full crosslinking and solvent resistance in the adhesive. The Norland Optical Adhesives have viscosities ranging from 300 to 5000 cps. It is, of course, essential that the adhesive have good permanent bonding properties to both of the bonded layers.

In the practice of the present invention, the adhesive layers have a thickness preferably in the range of 2-10 micrometers, and more preferably 4-8 micrometers.

E. Description of the Drawing

Figure 1, as aforementioned, illustrates the fabrication of a diffractive lens using a conventional approach, wherein a pattern is etched into a silicon dioxide ($SiO_2$) layer grown on a Si wafer, or directly onto an optically flat quartz plate forming a phase-only CGH. In this case a two-step photolithographic process with reactive ion etching (RIE) produces a 4-level approximation to the phase function describing the lens. The object (a) represents the surface of the lens; (b) is the lens kinoform, representing the lens surface curvature modulus 2p in a multisected form; (c) is the first two-level approximation to this surface, produced in a transparent material by a photolithographic masking process followed by etching; an additional masking step followed by etching produce object (d), which is the 4 level approximation of the kinoform. As also aforementioned, the maximum diffraction efficiency of these CGH's is 40% for the two level device and 81% for the four level device. Higher efficiency can be obtained by additional level etching of the $SiO_2$. This of course, makes additional photolithographic steps, which renders it an expensive and lengthy process.

Figures 2A-F refer to a preferred embodiment of the present invention.

Figure 2 illustrates a refractive index-modulatory photosensitive dry film 10, sandwiched between two temporary protective layers or films 12 and 14. The protective films 12 and 14 serve as temporary supports, between which the thin layer of the refractive index-modulatory photosensitive dry film 10, which is relatively thin and weak, is protected until it is ready to be used.

As aforementioned, the film 10 preferably has a thickness in the range of 20-60 micrometers. For thickness considerably lower than 20 micrometers or considerably higher than 60 micrometers, the diffraction efficiency drops rapidly.

At least one of the films 12 and 14 is preferably transparent so that radiation may pass through it. More preferably, both films are transparent and they belong to the polyester family, such as for example Mylar®. The two support films 12 and 14 may be removed easily by a peeling action.

Figure 2B shows a configuration of a relief image photomask-master 15 having a transparent flat portion 16, such as for example glass or quartz. The photomask-master 15 also has recessed areas 18 and protruding areas 20, contrasting in opacity and transparency which represent a binary intensity computer-generated hologram, made by conventional techniques, which are well known to the art.

In a preferred way of carrying out the present invention, the support film 14 is removed, preferably by a peeling action, and the refractive index-modulatory photosensitive dry film 10, now supported only by the support film 12, is laminated onto the photomask-master 15, so that it conforms to the recessed areas 18 and protruding areas 20, as shown In Figure 2C. As aforementioned, the conformation should be as complete as possible, in order to avoid undesirable light scattering, which will deteriorate the definition and resolution of the final volume phase hologram.

Preferably, this temporary laminate is heated to a temperature in the range of 30 to 80°C, more preferably in the range of 50 to 70°C, and is subjected to collimated radiation R1, as shown in Figure 4. The actinic radiation passes through the transparent areas or recessed areas 18, of the photomask-master 15, thereby hardening and effecting a change of at least 0.01 in the refractive index of the exposed areas 11 of the photosensitive dry film 10. In sequence, it is preferable to pass radiation R2 in a manner of flood exposure through the support film 12 in order effect hardening of the unexposed areas 13. The flood exposure is conducted for the purpose of fixing or "freezing" the refractive indices of the different portions of the film 10, so that no further substantial changes occur with time. This step considerably improves the reproducibility of the process.

After the flood exposure R2, the refractive index-modulatory photosensitive dry film 10, along with the support film 12, is removed, preferably peeled off the photomask-master 15 and it is laminated on a structure 25 better shown in Figure 2D. The structure 25 comprises a dimensionally stable transparent substrate 24 with a layer of an optical adhesive 26 laminated or otherwise applied on the substrate 24. It is preferable that the optical adhesive layer 26 is kept between two protective support films (in a similar manner as the refractive index- modulatory film) before its lamination to the dimensionally stable transparent substrate 24. The product of this operation is shown in Figure 2E. Thus, a strong bond is created between the refractive index-modulatory photosensitive dry film 10 and the dimensionally stable transparent substrate 24 through the optical adhesive 26. Thus the support film 12 may be easily peeled off without disturbing the optical contact of film 10 with the substrate 24. Although in some instances the adhesive may be omitted, its use is highly preferred for the above mentioned reasons, and because it provides considerably more rugged and dimensionally stable structures.

In sequence, a second structure similar to that shown in Figure 2D, comprising a dimensionally stable substrate 28 and a layer of an optical adhesive 30, is laminated on the remaining free surface of the dry film 10, so that a sandwich as illustrated in Figure 2F is formed. In this manner, the refractive index-modulatory photosensitive dry film 10 is secured between two transparent substrates 24 and 28 with optical adhesive 26 and 30 sandwiched thereinbetween. It is preferred that the two transparent substrates be identical in their configuration and properties.

Preferably, the final configuration shown in Figure 2F is symmetrical with respect to the refractive index-modulatory photosensitive dry film 10, regarding both optical and dimensional characteristics.

Other variations on this fabrication procedure are possible. For example the photosensitive polymer may be spun on to the substrate, such as glass or quartz, for example, and then exposed through the photomask-master, as mentioned above.

Applicants have constructed a large number of devices or elements containing volume phase holograms. One such element, consisting of an array of off-axis Fresnel zone plates (FZP), had a diffraction efficiency of 98%. Its design and fabrication are described below.

F. Fresnel Zone Plate

CGH FZPs are discrete representation of the radial phase variation of the desired lens. The phase shift imparted on a beam transmitted through a spherical lens with focal length $f_x$ in the X direction and $f_y$ in the Y direction is given by

$$\phi = (2\pi/\lambda)\{[(x^2 + f_x^2)^{1/2} + f_x] + [(y^2 + f_y^2)^{1/2} + f_y]\}$$

The phase shift $\phi_F$ of a Fresnel lens is given by dividing $\phi$ with a modulus $2\pi$

$$\phi_F = \phi - 2m\pi \qquad m = 1, 2, \ldots$$
$$0 < \phi F < \pi$$

It is clear that the group pf curves representing equal phases are concentric ellipses when $f_x \neq f_y$ and constitute an elliptical Fresnel lens, and when $f_x = f_y$ they are concentric circles and they form a circular Fresnel lens. A binary FZP is an element in which the phase is approximated only by the value 0 or $\pi$. The radii where the phase makes a transition of $\pi$ are (assuming $f_x = f_y$).

$$r_m = [\lambda f m + (m^2 \lambda^2/4]^{1/2} \quad m = 1, 2 \ldots$$

where $r_m$ are the zones radii

The phase is constant within the zones and varies by $\pi$ between two adjacent zones.

When $x \ll f_x$ and $y \ll f_y$ the following approximation can be used (the paraxial approximation):

$$\phi = (\pi/\lambda)(x^2/f_x + y^2/f_y).$$

In this approximation the zone radii are:

$$r_m = [\lambda f m]^{1/2}.$$

and the zones spacings are given by:

$$r_m = \lambda f/2 r_m.$$

The zones spacings decrease toward the lens periphery, thus for a lens with diameter D the minimum zone spacing will be

$$(\Delta r)_{min} = \lambda f/D = \lambda/2(N.A.)$$

where N.A. is the lens numerical aperture. If $\Delta r_o$ is the lithographically imposed limit on how small $\Delta r_{min}$ can be then

$$N.A. < \lambda/2\Delta r_o$$

With e-beam lithography $\Delta r_o$ can be as small as 0.25 micrometer. Thus, for example, for argon laser radiation with $\lambda = 0.514$, a Fresnel lens with a lens numerical aperture larger than 1 can be fabricated (on a thin sheet of Mylar® polyester film, for example).

Figure 3 illustrates a micrograph of four square-shaped FZP fabricated on a photomask-master, and then transferred to the refractive index-modulatory photosensitive dry film 10, as shown in Figures 2A-F and as described in the Example. These lenses have focal distance of 2.5 mm and diameter of 1 mm.

Figure 4 illustrates the principle in designing an off-axis Fresnel lens in the form of a photomask-master 215. Similarly to a conventional lens, in which an incoming parallel beam 240 impinges on the lens at a distance d from its center axis A-A', the beam will be deflected and focused at the lens focal point 242 at a focal distance f. Thus, off-center Fresnel lens design consists of selecting an appropriate section of the complete zone plate. This section constitutes the desired lens. Knowing d, f, and the beam diameter s, one can determine the initial and final values of the index m, which enumerates the zone radii, and thus find the desired plate section. A schematic representation of a micrograph of a part of an off-center lens fabricated on the photopolymer is shown in Figure 5. The lens size in this case is 2x2 mm$^2$ and the focal distance f = 12.5 cm. The resulting beam deflection at the focal plane is 20 mm.

## Example

All parts and percentages are given by weight, unless otherwise stated.

This example illustrates preparation of a transmission holographic optical element (HOE), wherein the optical element is a computer generated holographic optical element (CGHOE). The CGHOE was fabricated from three consumable parts: two similar dimensionally stable transparent sheet substrates having a pre-laminated optical adhesive layer, and a refractive index-modulatory photosensitive dry film in the form of a photohardenable film comprising a transmission volume phase HOE. This was recorded by exposure through a photomask-master as a change in refractive index in refractive index-modulatory photosensitive dry film.

The transparent substrate, which served as a protective layer and provided mechanical support, was 0.85 mm thick Lucite® polymethyl methacrylate sheet. The optical adhesive layer was applied to the substrate in the form of a dry film by hot roll lamination. The optical adhesive dry film was prepared by machine coating the photopolymerizable composition described below onto a 12.7 micrometer polyethylene terephthalate film; a 25.4 micrometer polyethylene film was used as an interleaf on the other side of the optical adhesive dry film, the thickness of which was 8.0 micrometers.

The composition of the dry optical adhesive layer was as follows:

TABLE 1

| Composition of Optical Adhesive Layer | |
|---|---|
| Ingredient | Amount (g) |
| Elvacite® 2051 | 32.40 |
| Vinac® B-15 | 12.64 |
| TMPTMA | 35.55 |
| TEOTA | 7.90 |
| o-Cl-HABI | 1.58 |
| 2-Mercaptobenzoxazole | 0.71 |
| Tinopal® PCR | 0.20 |
| Tinopal® SFG | 0.99 |
| Cyasorb® UV-24 | 0.08 |
| Brij® 30 | 7.90 |
| Hydroquinone | 0.05 |
| TAOBN | 0.03 |

The refractive index-modulatory photosensitive dry film as a consumable element was fabricated by machine web-coating of the photopolymerizable composition described below onto a 50.8 micrometer Mylar® polyester film; a 25.4 micrometer Mylar film was used as an interleaf protective layer. The refractive index-modulatory photosensitive dry film was 40 micrometer thick.

The composition of the refractive index-modulatory photosensitive dry layer was as follows:

TABLE II

| Composition of Refractive Index-Modulatory Photosensitive Layer | |
|---|---|
| Ingredient | Amount (g) |
| CAB 531-1 | 52.00 |
| N-vinyl carbazole | 6.0 |
| Photomer 4039 | 27.00 |
| Sartomer 349 | 10.00 |
| MT | 2.52 |
| o-Cl-HABI | 2.48 |
| FC-430 | 0.10 |
| Methylene Chloride | 285.00 |
| Methanol | 15.00 |

Lamination of the Adhesive Layer to the Dimensionally Stable Transparent Substrate

9

In order to obtain better support during lamination, the dimensionally stable transparent substrate was placed on a temporary carrier sheet of a commercial color proofing receptor (CROMALIN Masterproof Commercial Receptor, Product No. CM/CR, E. I. du Pont de Nemours and Company, Inc., Wilmington, DE). The optical adhesive film was laminated to the substrate using a CROMALIN® laminator operating at a roll surface temperature of 115-124°C.

Photolithographic Imaging of the Refractive Index-Modulatory Photosensitive Dry Film

The Interleaf Mylar® film was peeled off the refractive index-modulatory photosensitive dry film, and the base Mylar® supporting the uncovered film was laminated manually to the photomask-master using a photographic roller with the photohardenable layer facing the chromium surface of a conventional photomask-master made by the computer generated holographic techniques as described earlier. Due to the substantial tackiness of the refractive index-modulatory photosensitive dry layer, good lamination was obtained. The laminated "film-mask sandwich" was then placed on a pre-heated plate, which had reached a temperature of 70°C. After 2 minutes of heating, the heated laminate was exposed to radiation through the photomask-master by a collimated UV exposure unit (500 W OAI-UV Source, Model 30-7, Optical Associates, Inc., Milpitas, CA) at a distance of 5 cm (2 in) from the collimating lens of the UV source. The UV exposure intensity was 12 mW/cm$^2$.

After completing this imaging step, the "film-mask sandwich" was removed from the heating plate and it was flood overexposed through the transparent Mylar® base in a high intensity UV exposure unit (5 kW Variable Intensity OLITE Printing Light, model AL53-M, Olec Corp., Irvine, CA). The UV exposure intensity was 25 mW/cm$^2$.

Assembling of the Computer Generated Holographic Optical Element

After the flood exposure, the Mylar® film with the photoimaged layer was delaminated from the photomask-master, and the refractive index-modulatory photosensitive dry layer was immediately laminated to the uncovered (interleaf film peeled off) adhesive layer which was pre-laminated to the aforementioned polymethylmethacrylate substrate. The Mylar® base film was then delaminated from the refractive index-modulatory photosensitive dry layer, and the freed surface of the refractive index-modulatory photosensitive dry layer was laminated to the adhesive layer over another dimensionally stable substrate, thus completing the assembling step for this CGHOE. Additional flood overexposure with UV intensity of 25 mW/cm$^2$ was given to the assembled CGHOE to cure the adhesive layers and this completed fabrication of the said CGHOE.

A high quality CGHOE was fabricated by the above described method. Measurements of diffraction efficiencies of the assembled CGHOE were performed by a standard technique with He-Ne laser at 633 nanometers. Diffraction efficiencies of 93-98% were observed.

GLOSSARY

| | |
|---|---|
| Brij 30 | Polyoxyethylene (4) lauryl ether; Brij is a registered trademark of ICI |
| CAB 531-1 | Cellulose acetate butyrate from Eastman |
| Cyasorb UV-24 | (2-Hydroxy-4-methoxyphenyl) (2-Cyasorb is a registered trademark of American Cyanamid Co., Wayne, NJ |
| Elvacite 2051 | Poly(methyl methacrylate); MW = 350,000 Elvacite is a registered trademark of E. I. du Pont de Nemours and Co., Wilmington, DE |
| FC-430 | Fluoroaliphatic polymeric esters, 3M Company, St. Paul, MN |
| LUCITE | Trademark for cast acrylic sheet from E. I. du Pont de Nemours and Company, Wilmington, DE |
| MYLAR | Trademark for polyester film sold by E. I. du Pont de Nemours and Company, Wilmington, DE |
| MT | 4-methyl-4H-1,2,4-triazole-3-thiol; CAS 24854-43-1 |
| o-Cl-HABI | 1,1'-Biimidazole, 2,2'-bis[o-chlorophenyl] 4,4',5,5'-tetraphenyl-; CAS 1707-68-2 |
| Photomer 4039 | phenol ethoxylate monoacrylate; CAS 56641-05-5; Henkel Process Chemical Company |
| Sartomer 349 | ethoxylated bisphenol A diacrylate; CAS 24447-78-7; Sartomer Company, West Chester, PA |
| TAOBN | 1,4,4-Trimethyl-2,3-diazobicyclo-(3.2.2)-non-2-ene-2,3-dioxide. |

| TEOTA | Triacrylate ester of ethoxylatedtrimethylolpropane |
| --- | --- |
| Tinopal PCR | 2-(Stibyl-4'')-(naphtho-1',2',4,5)-1,2,3-triazol-2''-sulfonic acid phenyl ester Benzenesulfonic acid, 5-(2H-naphtho⟨1,2-D⟩-trizole-2-ly)-2-(2-phenylethyl)-, phenyl ester; CAS 6994-51-0; Tinopal® is a registered trademark of Ciba Geigy Corporation, Hawthorne, NY |
| Tinopal SFG | 3-Phenyl-7-[2'-(4'-N,N-diethylamino-6'-chloro-1',3',5'-triazinylamino]-coumarin; Ciba-Geigy |
| TMPTMA | Trimethylolpropane trimethacrylate; 2-ethyl-2-(hydroxymethyl)-1,3-propanediol trimethacrylate; CAS 3290-92-4 |
| Vinac B-15 | Poly(vinyl acetate); M.W. 90,000; CAS 9003-20-7; Vinac is a registered trademark of Air Products and Chemicals Corp., Allentown, PA |

## Claims

1. A method for forming a volume phase optical element comprising the steps of:

    (1) forming a relief image photomask-master having recessed and protruding areas which contrast in opacity and transparency and represent a binary intensity computer generated hologram;

    (2) applying a refractive index-modulatory photosensitive dry film on the photomask-master in a manner that one of the surfaces of the dry photosensitive film is in conformation with the relief image of the photomask master;

    (3) passing actinic radiation through the transparent areas of the photomask-master thereby hardening and effecting a change of at least 0.001 in the refractive index of the exposed areas of the photosensitive dry film;

    (4) removing the refractive index-modulatory photosensitive dry film from the photomask-master; and

    (5) laminating the refractive index-modulatory photosensitive dry film between two transparent substrates with optical adhesive sandwiched thereinbetween.

2. A method as defined in claim 1, further comprising a step of heating the photosensitive dry film to a temperature in the range of 30 to 80°C during step (3).

3. A method as defined in claim 1, further comprising a step of flood exposing the photosensitive dry film with actinic radiation to effect hardening of the unexposed areas in step (3).

4. A method as defined in claim 3, wherein the optical adhesive is photocurable, and the method further comprises a step of flood exposing the optical adhesive with actinic radiation in order to effect photocuring of said adhesive.

5. A method as defined in claim 4, further comprising a step of heating the photosensitive dry film at a temperature in the range of 30 to 80°C during step (3).

6. A method as defined in claim 5, wherein the two transparent substrates are substantially identical.

7. A method as defined in claim 5, wherein the refractive index of the photosensitive dry film is raised in the exposed areas from step (3).

8. A method as defined in claim 5, wherein the thickness of the refractive index-modulatory photosensitive dry film is 20-60 micrometers.

9. A method as defined in claim 1, wherein the two transparent substrates are substantially identical.

10. A method as defined In claim 1, wherein the refractive index of the photosensitive dry film is raised in the exposed areas from step (3).

11. A method as defined in claim 1, wherein the thickness of the refractive index-modulatory photosensitive dry film is 20-60 micrometers.

Fig. 1

Fig. 5

Fig. 2A

Fig. 2B

Fig. 2C

Fig. 2D

Fig. 2E

Fig. 2F

# Fig. 3

# Fig. 4